# EUROPEAN PATENT APPLICATION

(11) **EP 4 194 857 A1**
(43) Date of publication of application: **14.06.2023**
(21) Application number: 21213674.1
(22) Date of filing: 10.12.2021
(51) Int. Cl.: G01R 11/04, G01R 11/30

(54) **SMART TERMINAL BLOCK FOR AN ELECTRIC MOTOR**

(71) Applicant: ABB SCHWEIZ AG, 5400 Baden (CH)
(72) Inventor: SUTTON, Felix, 8048 Zürich (CH); SOMMER, Philipp, 8003 Zürich (CH); MARET, Yannick, 5405 Dättwil (CH); POLEDNIA, Filip, 43-300 Bielsko-Biala (PL)
(74) Representative: Zimmermann & Partner Patentanwälte mbB

(57) **Abstract**

A smart terminal block (100) for an electric motor (800), comprising a terminal block housing (160) and a plurality of terminal connectors (102A-102C) arranged at the terminal block housing (160). Additionally, the smart terminal block (100) further comprises, arranged at the terminal block housing (160): a sensor input unit (120) configured to receive sensor measurement data (122) indicative of a diagnostics parameter from a sensor unit; a processor (130) that is configured to receive the sensor measurement data (122) from the sensor input unit, to process the sensor measurement data (122), and to provide a processing output (132) indicative of a result of the processing of the sensor measurement data (122); and a signaling unit (140) that receives the processing output (132) and is configured to further relay the processing output (132).

## Description

### TECHNICAL FIELD

Embodiments of the present disclosure relate, in a first aspect, to a smart terminal block for an electric motor. In a second aspect, embodiments of the present disclosure relate to an electric motor comprising a smart terminal block according to the first aspect of the present disclosure.

### BACKGROUND

Electric motors are an integral component of a wide range of industrial systems. The reliability of such electric motors is extremely important due to the high efficiency and safety-critical nature of industrial systems, particularly in the oil & gas, food and beverage, (discrete) manufacturing, and pharmaceutical industries.

Like any electro-mechanical device, electric motors are susceptible to failures. The most common failure on an electric motor is the bearing, while other failure types include stator winding deterioration or rotor damage. In order to minimize downtime, and thus save operational costs, understanding the health condition of an electric motor, in a low-cost, easy to commission, and intuitive manner is most advantageous.

In addition, knowing more about the operating condition of the motor is particularly interesting also in view of the motor being over- or under-dimensioned for the application. In the case of an over- dimensioned motor, it may consume more energy than strictly needed, while an under-dimensioned motor may develop an early failure.

### GENERAL DESCRIPTION

In light of the above, a smart terminal block for an electric motor and an electric motor comprising a smart terminal block is disclosed.

The smart terminal block according to the first aspect of the present disclosure comprises a terminal block housing. Furthermore, the smart terminal block comprises, arranged at the terminal block housing, a plurality of terminal connectors each having a first contact terminal and a second contact terminal. Each of the first contact terminals is configured to receive a respective power-source connection line of an external electric power source and each of the second contact terminals is configured to receive a respective motor connection line to the electric motor, for establishing an electrical connection between the external electric power source and the electric motor.

Additionally, the smart terminal block comprises, arranged at the terminal housing, a sensor input unit, a processor, and a signaling unit.

The sensor input unit is configured to receive sensor measurement data indicative of a diagnostics parameter from a sensor unit. The processor is configured to receive the sensor measurement data from the sensor input unit, to process the sensor measurement data, and to provide a processing output indicative of a result of the processing of the sensor measurement data. Lastly, the signaling unit receives the processing output and is configured to further relay the processing output.

The smart terminal block is advantageous, because it allows to add diagnostics capabilities to an electric motor while keeping the required additional steps during assembly of the electric motor to a minimum and only adding little cost. This advantage is realized through including the diagnostics capabilities into the terminal block of the electric motor, which is already a part of IEC-standard and NEMA-standard motors. In IEC-standard and NEMA-standard motors, the terminal block is located in the motor terminal box, also referred to as conduit box. The motor terminal box is an enclosed housing that receives the power source connection lines of the external electric power source and the motor connection lines and where the external electric power source is electrically connected to the electric motor through the plurality of terminal connectors. By adding the diagnostics capabilities, the terminal block becomes a smart terminal block. The proposed smart terminal block complements the main functionality by including intelligent sensing for monitoring the operating condition of the electric motor. Moreover, the smart terminal block can be added to an electric motor during assembly as well as retro-fitted.

In the following, further preferred developments of the smart terminal block will be described.

In all of the disclosure, the term motor operating condition is to be understood to include, for example, a motor's health and a load condition of the electric motor. The diagnostics parameter can be any quantity measurable by a sensing device that can be used to determine that operating condition. Furthermore, the motor connection line it to be understood to also include those electrical connections that use brushes or similar to establish an electrical connection.

In preferred developments of the idea of the present disclosure, the plurality of the terminal connectors connects a rotor winding of a rotor of the electric motor and/or a stator winding of a stator of the electric motor to the external electric power source. In variants of these developments, the electrical connection is realized in a Y- and/or a D-configuration or any alternative supported by the motor.

In yet another preferred development, the processor of the smart terminal block is configured to process the sensor measurement data according to a diagnostics algorithm and to provide a diagnostics-result signal indicative of a result of the application of the diagnostics algorithm on the sensor measurement data. A processing of the sensor measurement data using diagnostics algorithm applied directly by the processor is advantageous, because it allows the smart terminal block to independently collect and analyze the sensor measurement data without the requirement of an additional external device. Examples of such diagnostics algorithms are given in, for example, WO 2020/128685 A1 and WO 2020/240404 A1.

In a variant of this development, the signaling unit receives the diagnostics-result signal provided by the processor and is configured to provide a human-perceivable diagnostics-indication signal that is indicative of the diagnostics-result signal. This variant is particularly advantageous, because it allows the smart terminal block to provide a human-perceivable signal indicative of an outcome of the application of the diagnostics algorithm directly at the electric motor, for example, to nearby service personal operating the electric motor.

In variants of this development, the signaling device is configured to provide a light signal or a sound signal, such as an alarm. In other variants, the signaling device is a display that is configured to visualize the processing output using text and/or graphics.

In another preferred development, the signaling unit is a wireless communication unit that receives the processing output of the processor and is configured to transmit the processing output wirelessly to an external reception device. Such a signaling unit is particularly advantages, because it allows the processor output to be further processed and analyzed by a different device. Moreover, it allows the electric motor on which the smart terminal block is mounted to be located at a different location than the external reception device.

Such a wireless output can be realized, for example, through a WIFI, a Bluetooth or a mobile telecommunication interface. Alternatively, the wireless output can also be realized through an infrared signal. Furthermore, the external reception device can be part of a computing device that allows an analysis of the processing output in the cloud.

In another development, the signaling unit is, alternatively or additionally, a wire-bound communication interface. Also, the wire-bound communication interface allows a further processing of the output of the processor at a different location. In variants of this development, the wire-bound communication interface is realized, for example, through a USB or ethernet interface. In other variants, the wire-bound interface is a display interface that allows the connection of a display to the smart terminal block.

In yet another preferred development, the smart terminal block comprises a sensor unit that is configured to measure the diagnostics parameter and to provide the sensor measurement data indicative of the diagnostics parameter to the sensor input unit. By also including the sensor unit into the smart terminal block, the number of steps required for an assembly of an electric motor can be further reduced. In variants of this embodiment, the sensor input is a conductor portion for conducting the sensor data to the processor.

In one variant of this development, the sensor unit comprises a vibration sensor, an acoustic sensor, a temperature sensor, humidity sensor and/or a magnetic flux sensor. In another variant of this development, the sensor unit comprises, alternatively or additionally, a current sensor that is configured to determine a current transmitted through at least one of the terminal connectors between the external electric power source and the electric motor. In another variant, the smart terminal block comprises a sensor unit and the sensor input unit is configured to provide the sensor measurement data of the sensor unit comprised within the smart terminal block as well as an external sensor unit to the processor. In this variant, the processor will be able to process sensor measurement data received from internal as well as external sensor units.

In a further development of the idea of the present disclosure, the smart terminal block comprises a power supply unit that is configured to provide electrical power to the processor and/or the signaling unit.

In a variant of this development, the electrical power supply unit comprises a power harvesting device. The use of a power harvest device is particularly advantageous, because it allows a further reduction of the number of assembly steps required to attach the smart terminal block to an electric motor. Moreover, the power harvesting device allows the smart terminal block to be power just by ambient energy sources. For example, in some variants, the power harvesting device is configured to harvest power from magnetic fields, vibrations, and/or temperature. In one of these variants, the power harvesting device comprises a coil for harvesting electrical power from magnetic fields.

In yet another variant of this development the electrical power supply unit comprises an electrical-energy storage unit. In some of those variants, the electrical-energy storage unit is a (non)-rechargeable battery or supercapacitor.

In another preferred variant of this development of the present disclosure, the electrical power supply unit is electrically connected to one of the terminal connectors and configured to use at least a part of the electrical power supplied by the external electrical power source to power the processor and/or the signaling unit.

In some of the variants of the smart terminal block that also comprise a sensor unit, the power supply is configured to provide electrical power also to the sensor unit.

In another development of the idea of the present disclosure, the processor is attached to an outside wall of the terminal block housing. Such an arrangement is particularly advantageous for an efficient assembly of the smart terminal block.

In case, the smart terminal block also comprises a sensor unit or an electrical power supply unit, in variants of this development, the sensor unit and/or the electrical power supply unit are also arranged at the outside wall of the terminal block housing.

In another development of the idea of the present disclosure, the smart terminal block comprises a mounting element for mechanically mounting the terminal block housing to the electric motor. Such a mounting element is advantageous to securely attach the smart terminal block to the electric motor. In those cases, in which the smart terminal block comprises a sensor unit with a vibration sensor, the mounting element is also advantageous so ensure that an intensity of vibration measured by the sensor unit does indeed represent the vibrations of the electric motor.

In other preferred developments, the terminal block housing is made of a non-conducting material, such as polycarbonate.

In a second aspect, an electric motor comprising the smart terminal block according to the first aspect of the present disclosure is disclosed. The electric motor according to the second aspect of the present disclosure shares all the advantages of the smart terminal block according to the first aspect of the present disclosure.

In a preferred development of this second aspect of the present disclosure, the smart terminal block is preferably mounted in a motor terminal box of the electric motor.

### Brief Description of the Drawings

So that the manner in which the above recited features of the present disclosure can be understood in detail, a more particular description of the disclosure, briefly summarized above, may be had by reference to the embodiments. The accompanying drawings relate to embodiments of the disclosure and are described in the following:
- Fig. 1A: shows an embodiment of a smart terminal block for an electric motor according to the first aspect of the present disclosure;
- Fig. 1B: shows an embodiment of a processor as comprised in the smart terminal block depicted in Fig. 1A;
- Fig. 2: shows another embodiment of a smart terminal block according to the idea of the present disclosure, wherein the smart terminal block additionally comprises a power supply unit and wherein the smart terminal block comprises a signaling unit that is a wire-bound communication interface;
- Fig. 3A: shows yet another embodiment of a smart terminal according to the idea of the present disclosure, wherein the smart terminal block comprises a sensor unit and is configured to provide a human-perceivable light signal indicative of a health status of an electric motor;
- Fig. 3B: shows an embodiment of a processor as comprised in the smart terminal block depicted in Fig. 3A;
- Fig. 3C: shows an embodiment of a sensor unit as comprised in the smart terminal block depicted in Fig. 3A;
- Fig. 4: shows a detailed view of a terminal block housing of another embodiment of the smart terminal block according to the idea of the present disclosure;
- Fig. 5A: shows a front view of an electric motor comprising a smart terminal block according to the second aspect of the present disclosure; and
- Fig. 5B: shows a top view of the electric motor depicted in Fig. 5A.

### DETAILED DESCRIPTION OF THE EMBODIMENTS

Reference will now be made in detail to the various embodiments, one or more examples of which are illustrated in each figure. Each example is provided by way of explanation and is not meant as a limitation. For example, features illustrated or described as part of one embodiment can be used on or in conjugation with any other embodiment to yield yet a further embodiment. It is intended that the present disclosure includes such modifications and variations.

Within the following description of the drawings, the same reference numbers refer to the same or to similar components. Generally, only the differences with respect to the individual embodiments are described. Unless specified otherwise, the description of a part or aspect in one embodiment can apply to a corresponding part or aspect in another embodiment as well.

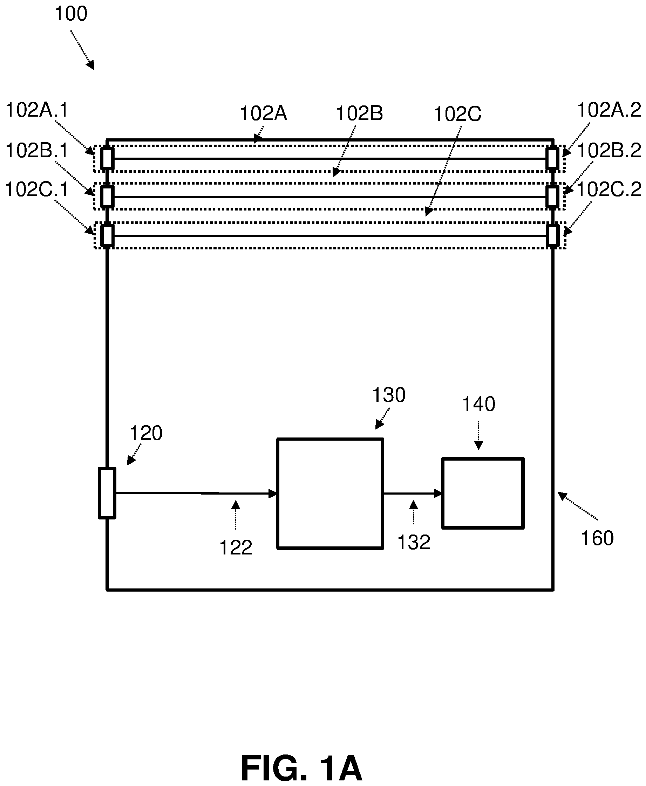

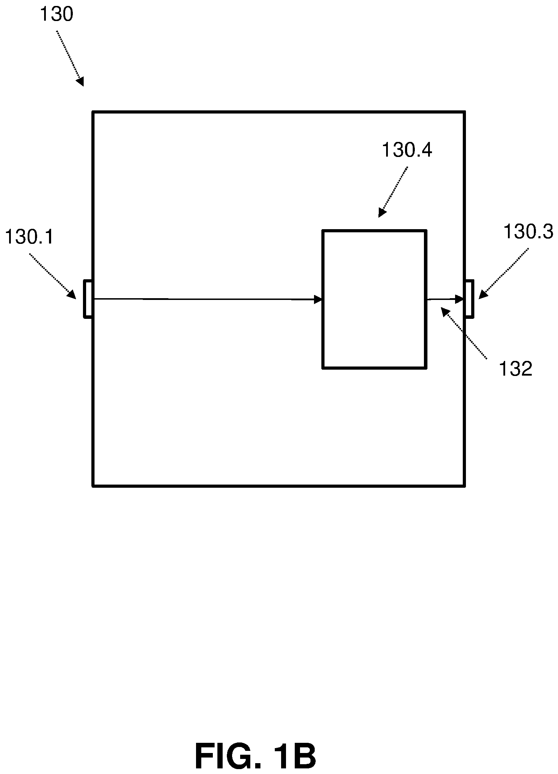

In the following, a first embodiment 100 of a smart terminal block will be described with reference to Fig. 1A and Fig. 1B.

Fig. 1A shows an embodiment 100 of a smart terminal block for an electric motor according to the first aspect of the present disclosure.

The smart terminal block 100 comprises a terminal block housing 160 that serves as a housing at or within which a number of components of the smart terminal block 100 are located, which will be described in more detail in the following.

Within and at the terminal block housing 160, three terminal connectors 102A-102C are located, wherein each of the terminal connectors 102A-102C has a first contact terminal 102A. 1-102C.1 and a second contact terminal 102A.2-102C.2. Each of the first contact terminals 102A.1-102C.1 is configured to receive a power-source connection line of an external electric power source (not shown in the Fig. 1A). Furthermore, each of the second contact terminals 102A.2-102C.2 is configured to receive a respective stator connection line of a stator of the electric motor. Moreover, each of the three terminal connectors 102A-102C is configured to establish an electrical connection between the external electric power source and a stator winding of a stator of the electric motor. In total six bolts and metal contacts (not visible in Fig. 1A) are used to establish the electrical connection. In the embodiment shown in Fig. 1A, the terminal connectors 102A-102C are configured to connect the stator winding of the electric motor to the external electric power source in a Y-configuration. However, other embodiments are configured to establish an electrical connection in, for example, a D-configuration.

Additionally, the smart terminal block 100 comprises within the terminal block housing 160 a sensor input unit 120 that is configured to receive sensor measurement data 122 indicative of a diagnostics parameter. In the embodiment 100 of the smart terminal block shown in Fig. 1A, the sensor input unit 120 is a sensor connection terminal that is configured to receive the sensor measurement data 122 from an external sensor unit (not shown).

Furthermore, the smart terminal block 100 comprises within the terminal block housing 160 a processor 130 that receives the sensor measurement data 122 from the sensor input unit 120 and is configured to process the sensor measurement data 122 and provide a processing output 132 indicative the processing of the sensor measurement data 122.

Lastly, the smart terminal block 100 comprises within the terminal block housing 160 a signaling unit 140 that receives the processing output 132 and is configured to further relay the processing output 132. In the embodiment 100 of the smart terminal block shown in Fig. 1A, the signaling unit 140 is a WIFI interface that is configured to relay the processing output 132 to an external device, such as a smart phone or a computer hosting a cloud computing service. In those embodiments, for example, a Bluetooth LE, LoRa, and SigFox interface is used as the signaling unit.

In the following, the processor 130 will be described in greater detail with reference to Fig. 1B.

Fig. 1B shows an embodiment of the processor 100 as comprised in the smart terminal block 100 depicted in Fig. 1A.

As shown in Fig. 1B, the processor 130 comprises a sensor-data input terminal 130.1 that is configured to receive the sensor measurement data 122 from the sensor input unit 120.

Furthermore, the processor 130 comprises an output-formatting unit 130.4 that receives the sensor measurement data 122 from the sensor-data input terminal 130.1 and is configured to process the sensor-measurement data 122 and provide, as the processing output 132, formatted sensor measurement data that corresponds to the sensor measurement data 122 formatted in such a way that it can be send via the signaling unit 140 to the external computing device.

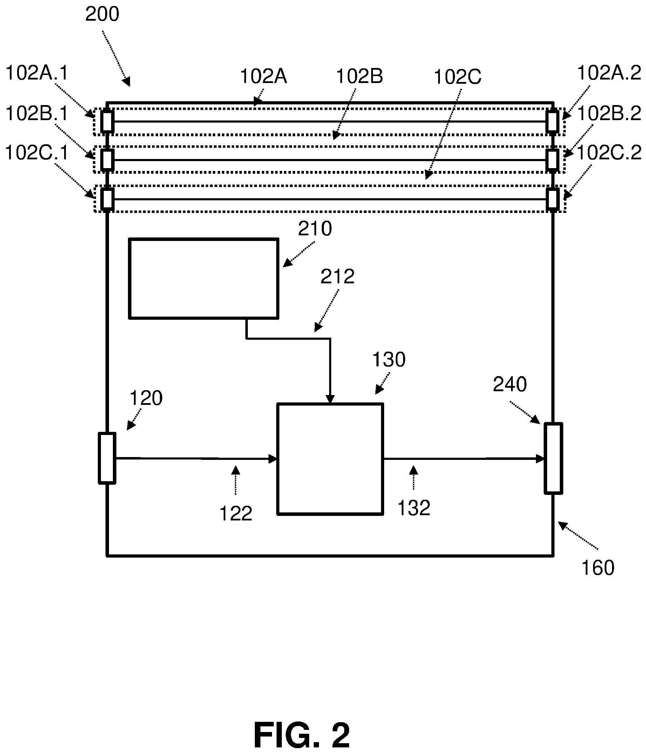

In the embodiment 100 of the smart terminal block, the processor 130 and the signaling unit 140 are provided with electric power by an external power supply to which the two components can be connected via a power-supply terminal not shown in Fig. 1A. However, with regard to the assembly process of an electric motor, it can also be advantageous when a power supply unit that is configured to provide electric power to at least one of the two components is itself comprised within the smart terminal block. Such an embodiment will be described in the following with reference to Fig. 2.

Fig. 2 shows another embodiment 200 of a smart terminal block according to the idea of the present disclosure, wherein the smart terminal block 200 additionally comprises a power supply unit 210 and wherein the smart terminal block 200 comprises a signaling unit 240 that is a wire-bound communication interface.

In the embodiment of the smart terminal block 200, the power supply unit 210 is a battery that is configured to provide electrical power to the processor 130 via an electrical connection line 212.

Additionally, and in contrast to the smart terminal block 100, the smart terminal block 200 comprises a signaling unit 240 that is a wire-bound communication interface and that is configured to externally provide the processing output 132 via a USB interface. In other embodiments, an RS485 interface is used.

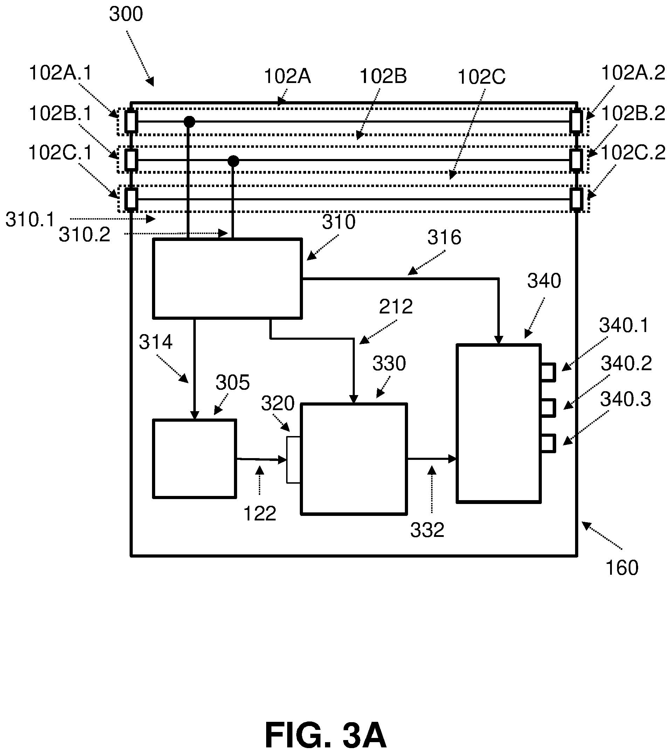

The smart terminal block 100 and the smart terminal block 200 are configured to provide the sensor measurement data either through a wireless connection or a wire-bound connection to an external device. However, in certain situations it is advantageous to show an indication of the processing output 132 directly at the electric motor. An embodiment that is configured to do so will be described in the following with reference to Figs. 3A-3C.

Fig. 3A shows yet another embodiment of a smart terminal block according to the idea of the present disclosure, wherein the smart terminal block comprises a sensor unit and is configured to provide a human-perceivable light signal indicative of a health status of an electric motor.

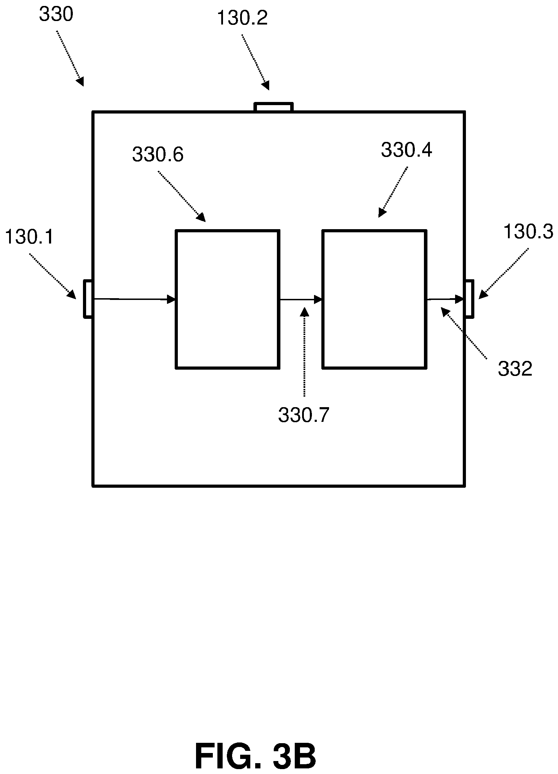

In contrast to the smart terminal block 100 and 200 shown in Fig. 1 and Fig. 2, the smart terminal block 300 comprises a processor 330 that receives the sensor measurement data 122 and is configured to apply a diagnostics algorithm to the sensor measurement data 122 that determines the health status of the electric motor. How this is performed will be described in the following with reference to Fig. 3B.

Fig. 3B shows the embodiment 330 of the processor as comprised in the smart terminal depicted in Fig. 3A.

The processor 330 receives the sensor measurement data 122 via the sensor-data input terminal 130.1. The sensor measurement data 122 is then forwarded to a diagnostics-computation unit 330.6, which is configured to process the sensor measurement data 122 according to a diagnostics algorithm in order to determine the health condition of an electric motor to which the smart terminal block 300 may be attached. A result signal 330.7 indicative of the health condition is then provided to an output-formatting unit 330.4. The output-formatting unit 330.4 is configured to process the result signal 330.7 and provide a diagnostics-result signal 330.5, which corresponds to the result signal 330.7 formatted in such a manner that is can be provided to the signaling unit 340. The electrical power supplied by the electrical-power supply unit 310 is receives via an electrical-power input terminal 130.2.

The signaling unit 340 of the smart terminal block 300 is a light-emitting device comprising three LEDs 340.1-340.3, wherein each of the LEDs is configured to emit human-perceivable light in a different color. The signaling unit 340 is configured to indicate the health status as determined by the processor by emitting light from one or more of the LEDs 340.1-340.3.

The light-emitting device 340 is only an example of the different realizations of the signaling unit of the smart terminal block. In other embodiments of the smart terminal block, a light-emitting device with bi- or tri-color LEDs is used. In yet other embodiments, the signaling unit is sound-emitting device that is configured to provide a sound signal indicative of the health condition. In yet other embodiments, the signaling unit is a display device that is configured to display text and or graphics indicative of the determined health status. In yet other embodiments, the signaling unit is configured to project colors or pictures indicative of the health condition.

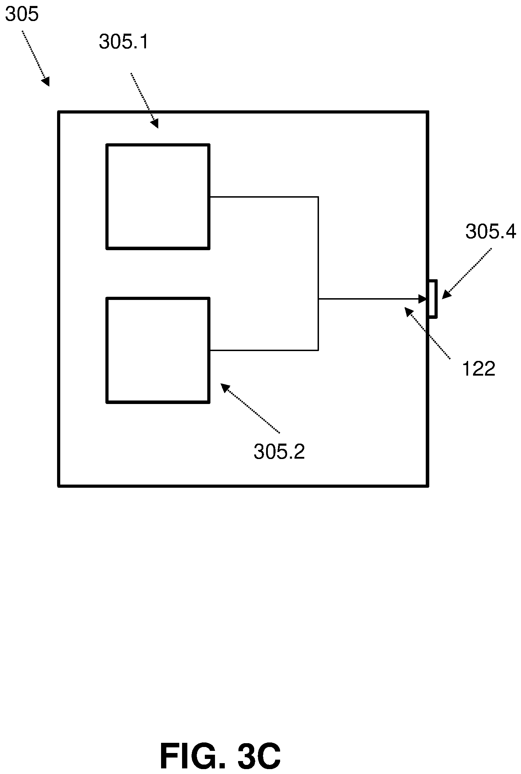

Moreover, the smart terminal block 300 differs from the embodiments of the smart terminal blocks 100 and 200 in that the smart terminal block 300 comprises an internal sensor unit 305 that is configured to determine a diagnostics parameter and to provide the sensor measurement data 122 indicative of those diagnostics parameters to the processor 330. A detailed description of the sensor unit 305 will be given in the following with reference to Fig. 3C.

Fig. 3C shows an embodiment of the sensor unit 305 as comprised in the smart terminal block 300 depicted in Fig. 3A.

As shown in Fig. 3C, the sensor unit 305 comprises two sensing devices 305.1 and 305.2. The sensing device 305.1 is a vibration sensor configured to measure vibrations of the smart terminal block 300 and to provide those parts of the sensor measurement data 122 indicative of the vibration measurements. The sensing device 305.2 is a temperature sensor configured to measure an ambient temperature of the smart terminal block 300 and, likewise, provide those parts of the sensor measurement data 122 that are indicative of the ambient temperature. The sensor measurement data 122 comprising information indicative of the measured vibration as well as the measured ambient temperature are provided to the processor 330 through a sensor-output terminal 305.4 of the sensor unit 305. The sensor measurement data 122 are received by the processor 330 through a sensor input unit 320, which is a conductor portion at an input terminal of the processor 330.

The sensor unit 305 with the sensing devices 305.1 and 305.2 is only shown for exemplary purposes. In other embodiments of the smart terminal block, the sensor unit also comprises other sensing devices, such as, for example, a MEMS accelerometer or a piezo electric element.

Lastly, the smart terminal block 300 also comprises an electrical-power supply unit 310 that is configured to branch off electrical power supplied to the terminal connectors 102A and 102B via electrical connections 310.1 and 310.2 and to supply the branched-off electrical power via the electrical connections 316, 212, and 314 to the signaling unit 340, to the processor 130, and to the sensor unit 305, respectively.

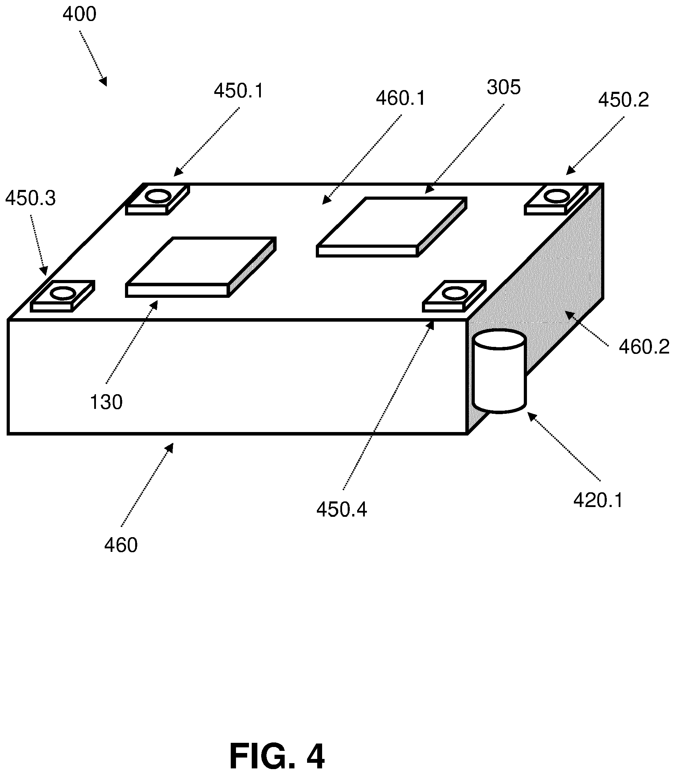

For further ease of assembling of the electric motor, some embodiments of the smart terminal block are constructed in such a way that certain components of the smart terminal block are located at an outside wall of the terminal block housing. Such an embodiment will be described in the following with reference to Fig. 4.

Fig. 4 shows a detailed view of a terminal block housing of another embodiment 400 of the smart terminal block that comprises a number of components which are located at an outside wall of a terminal block housing 460.

Fig. 4 shows the outside wall 460.1, which forms a bottom-side wall of the smart terminal block 400 and faces, when mounted onto an electric motor, a motor frame of the electric motor. Located on the bottom-side wall 460.1 is the processor 130 and the sensor unit 305. Moreover, for mechanically mounting the smart terminal block 400 onto the motor frame, the bottom-side wall 460.1 also comprises mounting elements 450.1-450.4.

Additionally, the smart terminal block 400 has a power supply unit 420 that comprises a coil 420.1 for harvesting electric energy from magnetic fields surrounding terminal connectors 102A-102C. The coil 420.1 is attached to another outside wall 460.2 of the terminal block housing 460. Furthermore, the terminal block housing 460 is shaped such that there is electrical isolation in the surrounding of the coil 420.1.

In the embodiment shown in Fig. 4, the terminal block housing 460 is made of plastic with dimensions of approximately 4cm (height) x 8cm (width) x 8cm (length).

Not visible in Fig. 4 are the terminal connectors 102A-102C of the smart terminal block 400, which are located on a top-side wall of the terminal block housing 460, which faces, when mounted in a motor terminal box of the electric motor, a terminal box lid of the motor terminal box.

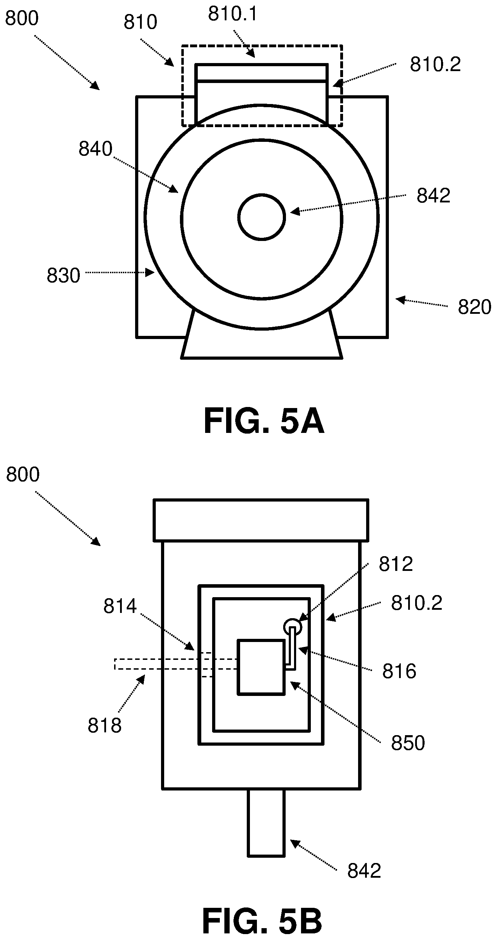

In the following, an electric motor comprising a smart terminal block according to the second aspect of the present disclosure will be described with reference to Fig. 5A and Fig. 5B.

Fig. 5A shows a front view of an electric motor 800 comprising a smart terminal block 850 according to the first aspect of the present disclosure.

The electric motor comprises a shaft 842 for transmitting mechanical torque generated by the electric motor 800. For generating that mechanical torque, the electric motor comprises a rotor 840 with a rotor winding (not visible) and a stator 830 with a stator winding (not visible).

Furthermore, the electric motor 800 is an IEC-standard motor and comprises a motor terminal box 810 that is located on top of a motor frame 820 of the electric motor 800. The motor terminal box 810 comprises a terminal box body 810.2 and a terminal box lid 810.1. In other embodiments, the electric motor is a NEMA-standard motor, wherein the motor terminal box is located on a side of the electric motor. Inside the motor terminal box 810, the smart terminal block 850 is located, which will be described further with reference to Fig. 5B.

Fig. 5B shows a top view of the electric motor depicted in Fig. 5A.

In the top view of the electric motor 800, the terminal box lid 810.1 of the motor terminal box 810 is removed, which allows to view an inside of the motor terminal box 810.

As has already been mentioned above, the smart terminal block 850 is located within the motor terminal box 810. The motor terminal box 810 is an enclosed housing in which stator terminals of the electric motor 800 are connected to an external electric power source, such as a power grid. A power-source connection line 818 (indicated with a dashed line) from an external electrical power source can be led through a first through-hole 814 into the inside of the motor terminal box 810. Furthermore, a motor connection line 816 is led through a second through hole from the stator 830 of the electric motor 800 into the inside of the motor terminal box 810. The motor connection line 816 and the power-source connection line 818 are electrically connected to each other through the terminal connectors of the smart terminal block 850.

In summary, the present disclosure related to a smart terminal block (100) for an electric motor (800), comprising a terminal block housing (160) and a plurality of terminal connectors (102A-102C) arranged at the terminal block housing (160). Additionally, the smart terminal block (100) further comprises, arranged at the terminal block housing (160): a sensor input unit (120) configured to receive sensor measurement data (122) indicative of a diagnostics parameter from a sensor unit; a processor (130) that is configured to receive the sensor measurement data (122) from the sensor input unit, to process the sensor measurement data (122), and to provide a processing output (132) indicative of a result of the processing of the sensor measurement data (122); and a signaling unit (140) that receives the processing output (132) and is configured to further relay the processing output (132).

## Claims

1. A smart terminal block (100) for an electric motor (800), comprising
- a terminal block housing (160);
- a plurality of terminal connectors (102A-102C) arranged at the terminal block housing (160), each of the terminal connectors (102A-102C) having a first contact terminal (102A.1-102C.1) configured to receive a power-source connection line (818) of an external electric power source and a second contact terminal (102A.2-102C.2) configured to receive a respective motor connection line (816) to the electric motor (800), for establishing an electrical connection between the external electric power source and the electric motor; wherein
the smart terminal block (100) further comprises, arranged at the terminal block housing (160):
- a sensor input unit (120) configured to receive sensor measurement data (122) indicative of a diagnostics parameter from a sensor unit;
- a processor (130) that is configured to receive the sensor measurement data (122) from the sensor input unit, to process the sensor measurement data (122), and to provide a processing output (132) indicative of a result of the processing of the sensor measurement data (122), and
- a signaling unit (140) that receives the processing output (132) and is configured to further relay the processing output (132).

2. The smart terminal block (300) according to claim 1, wherein the processor (330) is configured to process the sensor measurement data (122) according to a diagnostics algorithm and to provide a diagnostics-result signal (332) indicative of a result of the application of the diagnostics algorithm on the sensor measurement data (122).

3. The smart terminal block (300) according to claim 2, wherein the signaling unit (140) receives the diagnostics-result signal (332) and is configured to provide a human-perceivable diagnostics-indication signal that is indicative of the diagnostics-result signal (332).

4. The smart terminal block (100) according to any of the preceding claims, wherein the signaling unit (140) is a wireless communication unit that receives the processing output (132) of the processor (132) and is configured to transmit the processing output (132) wirelessly to an external reception device.

5. The smart terminal block (200) according to any of the preceding claims, wherein the signaling unit (240) is a wire-bound communication interface.

6. The smart terminal block (300) according to any of the preceding claims, comprising a sensor unit (305) that is configured to measure the diagnostics parameter and to provide the sensor measurement data (122) indicative of the diagnostics parameter to the sensor input unit (320).

7. The smart terminal block (400) according to any of the preceding claims comprising a power supply unit (210) that is configured to provide electrical power to the processor (130) and/or the signaling unit (140).

8. The smart terminal block (400) according to claim 7, wherein the electrical power supply unit (210) comprises a power harvesting device (420.1).

9. The smart terminal block (400) according to claim 7 or 8, wherein the electrical power supply unit (210) is electrically connected to one of terminal connectors (102A-102C) and configured to use at least a part of the electrical power supplied by the external electrical power source to provide the electrical power to the processor (130) and/or the signaling unit (140).

10. The smart terminal block (100) according to claims 7-9, wherein the electrical power supply unit (210) comprises an electrical-energy storage unit.

11. The smart terminal block (400) according to any of the preceding claims, wherein the processor (130) is attached to an outside wall (460.1) of the terminal block housing (460).

12. The smart terminal block (400) according to any of the preceding claims comprising a mounting element (450.1-450.4) for mechanically mounting the terminal block housing (160) to the electric motor (800).

13. An electric motor (800) comprising the smart terminal block (100) according to one of the preceding claims.
